# EUROPEAN PATENT APPLICATION

(11) **EP 4 815 682 A1**
(43) Date of publication of application: **30.09.2026**
(21) Application number: 25182240.9
(22) Date of filing: 12.06.2025
(51) Int. Cl.: H10F 77/14, H10F 77/20

(54) **SOLAR CELL AND PHOTOVOLTAIC MODULE**

(30) Priority: 28.03.2025 CN 202510399187
(71) Applicant: Zhejiang Jinko Solar Co., Ltd., Haining, Zhejiang 314416 (CN)
(72) Inventor: YANG, Jie, Haining, Zhejiang, 314416 (CN); LI, Huimin, Haining, Zhejiang, 314416 (CN); XIA, Yi, Haining, Zhejiang, 314416 (CN); XU, Menglei, Haining, Zhejiang, 314416 (CN); ZHANG, Xinyu, Haining, Zhejiang, 314416 (CN)
(74) Representative: Balder IP Law, S.L.

(57) **Abstract**

A solar cell includes: a substrate, where the substrate has a first surface and a second surface opposite to the first surface, the first surface has first regions and second regions alternatingly arranged thereon, and the second regions are grooves with respect to the first regions; a passivation contact structure located at least over the first regions, where the passivation contact structure has a first side surface abutting one of the grooves, the one of the grooves has a second side surface, one of the first side surface and the second side surface has a recess recessed; a passivation layer covering a surface of the passivation contact structure and inner wall surfaces of the grooves; and a first electrode arranged on the passivation layer and electrically connected to the passivation contact structure. The solar cell can at least improve the photoelectric conversion efficiency.

## Description

### TECHNICAL FIELD

Embodiments of the present disclosure relate to the technical field of photovoltaics, and in particular to a solar cell and a photovoltaic module.

### BACKGROUND

Currently, as fossil fuels are gradually depleted, solar cells are becoming increasingly widely used as a new alternative energy source. Solar cells are devices that convert solar light energy into electrical energy. Solar cells generate carriers based on the photovoltaic effect, and then the carriers are led out using electrodes, thereby facilitating the efficient utilization of electrical energy.

Current solar cells mainly include interdigitated back contact (IBC) cells, tunnel oxide passivated contact (TOPCON) cells, passivated emitter and rear cells (PERC), and heterojunction cells. These cells aim to reduce optical losses and minimize photogenerated carrier recombination at the surface or within the silicon substrate to improve the photoelectric conversion efficiency of solar cells by utilizing various film layer configurations and functional constraints.

However, the current photoelectric conversion efficiency of solar cells is still unsatisfactory.

### SUMMARY

Embodiments of the present disclosure provide a solar cell and a photovoltaic module, which at least contribute to improving the photoelectric conversion efficiency of the solar cell.

Some embodiments of the present disclosure provide a solar cell including: a substrate. The substrate has a first surface and a second surface opposite to the first surface. The first surface has first regions and second regions alternatingly arranged thereon. The second regions are grooves with respect to the first regions. The solar cell further includes a passivation contact structure located at least over the first regions. The passivation contact structure has a first side surface abutting one of the grooves, the one of the grooves has a second side surface connected to the first side surface, one of the first side surface and the second side surface has a recess recessed inward along a first direction. The recess includes a first facet and a second facet connected to the first facet. The first facet is connected to an adjacent first region, and a first obtuse angle is formed between the first facet and the second facet. The first direction is a direction pointing from a respective second region towards an adjacent first region. The solar cell further includes a passivation layer formed over the passivation contact structure and the grooves. The solar cell further includes a first electrode arranged on the passivation layer and electrically connected to the passivation contact structure.

In some embodiments, the recess is formed on a side surface of the one of the grooves, and a ratio of a length of the second facet to a length of the first facet ranges from 8 to 30.

In some embodiments, a depth of the recess along the first direction is less than or equal to 200 nm.

In some embodiments, the passivation contact structure includes a tunneling dielectric layer and a doped semiconductor layer. The tunneling dielectric layer is located on the first regions. The doped semiconductor layer is located on the tunneling dielectric layer. The recess is formed on a side surface of the doped semiconductor layer. The ratio of the length of the second facet to the length of the first facet ranges from 8 to 30.

In some embodiments, the doped semiconductor layer is doped with an N-type doping element, and the depth of the recess along the first direction is less than or equal to 800 nm.

In some embodiments, the doped semiconductor layer is doped with a P-type doping element. The doped semiconductor layer includes a first portion and a second portion connected to the first portion. The first portion is located on the tunneling dielectric layer. The second portion extends along an end of the first portion to an adjacent groove. The recess is formed on a side surface of the second portion.

In some embodiments, a depth of the recess along the first direction is less than or equal to 200 nm.

In some embodiments, a length of the second portion along the first direction is less than or equal to 1 µm.

In some embodiments, inner wall surfaces of the grooves have micro-textured structures including pyramidal structures, quasi-pyramidal structures, prismatic structures, or quasi-prismatic structures.

In some embodiments, the passivation layer covers the first facet and the second facet. The passivation layer has a third side surface and a fourth side surface. The third side surface corresponds to the first facet. The fourth side surface corresponds to the second facet. A second obtuse angle is formed between the third side surface and the fourth side surface, and the second obtuse angle is less than or equal to the first obtuse angle.

In some embodiments, the first obtuse angle ranges from 100 ° to 140 °.

In some embodiments, a third obtuse angle is formed between a bottom surface of the groove and a side surface of the groove, and the third obtuse angle ranges from 110 ° to 150 °.

In some embodiments, the solar cell further includes: a second electrode located on the second surface.

In some embodiments, the solar cell further includes: a second passivation contact structure, where the second passivation contact structure is located in the second regions, and the passivation layer covers the second passivation contact structure; and a second electrode, located on the second regions and electrically connected to the second passivation contact structure.

Some embodiments of the present disclosure further provide a photovoltaic module, including: a cell string, formed by connecting multiple solar cells as described above; an encapsulation film, configured for covering a surface of the cell string; and a cover plate, configured for covering a surface of the encapsulation film facing away from the cell string.

### BRIEF DESCRIPTION OF THE DRAWINGS

One or more embodiments are illustrated through the figures in the corresponding drawings. These exemplary illustrations do not constitute limitations on the embodiments unless otherwise stated. The figures in the accompanying drawings do not constitute a scale limitation. In order to illustrate the technical solutions in the embodiments of the present disclosure or in the conventional technology more clearly, the drawings used in the description of the embodiments are briefly described below. It is apparent that the drawings in the following description show only some embodiments of the present disclosure, and other drawings may be obtained by those of ordinary skill in the art based on these drawings without any creative efforts.
Fig. 1 is a cross-sectional view of a solar cell according to an embodiment of the present disclosure;
Fig. 2 is a scanning electron microscope (SEM) image of the junction between one first region and one second region in the solar cell according to an embodiment of the present disclosure;
Fig. 3 is a partial enlarged view of the second region in Fig. 2;
Fig. 4 is another SEM image of the junction between the first region and the second region in the solar cell according to an embodiment of the present disclosure;
Fig. 5 is a partial enlarged view of the recess in Fig. 4;
Fig. 6 is yet another SEM image of the junction between the first region and the second region in the solar cell according to an embodiment of the present disclosure;
Fig. 7 is a partial enlarged view of portion B in Fig. 6;
Fig. 8 is a partial enlarged view of the recess in Fig. 6;
Fig. 9 is a further SEM image of the junction between the first region and the second region in the solar cell according to an embodiment of the present disclosure;
Fig. 10 is a partial enlarged view of the junction in Fig. 9;
Fig. 11 is a partial enlarged view of the recess in Fig. 10;
Fig. 12 is a cross-sectional view of another solar cell according to an embodiment of the present disclosure;
Fig. 13 is a cross-sectional view of the solar cell according to another embodiment of the present disclosure;
Fig. 14 is a cross-sectional view of a photovoltaic module according to an embodiment of the present disclosure; and
Fig. 15 is another cross-sectional view of the photovoltaic module according to an embodiment of the present disclosure.

### DETAILED DESCRIPTION OF THE EMBODIMENTS

As indicated in the background art, the photoelectric conversion efficiency of current solar cells remains unsatisfactory.

The embodiments of the present disclosure provide a solar cell that addresses this limitation through the following structural innovations: first light-trapping structures are formed by providing uneven first regions and second regions; and second light-trapping structures are formed by providing recesses on the side surface of the groove or the passivation contact structure, which further increases the internal reflection rate of incident light.

In the description of the embodiments of the present disclosure, technical terms such as "first", "second", etc., are merely used for distinguishing different objects and should not be construed as indicating or implying relative importance or as implicitly specifying the number, specific order, or priority of the technical features referred to. In the description of the embodiments of the present disclosure, the term "plurality/plural/multiple" refers to two or more, unless otherwise explicitly specified.

The mention of "embodiment" in this paper means that the specific features, structures, or characteristics described in conjunction with the embodiments may be included in at least one embodiment of the present disclosure. The appearance of this phrase at various locations in the specification does not necessarily refer to the same embodiment, nor is it an independent or alternative embodiment that is exclusive with other embodiments. Those skilled in the art can understand explicitly and implicitly that the embodiments described in this paper can be combined with other embodiments.

In the description of the embodiments of the present disclosure, the term "and/or" merely describes the associative relationship between associated objects, indicating that there can be three types of relationships. For example, A and/or B can represent three possible situations: sole existence of A, existence of both A and B, and sole existence of B. Additionally, the character "/" in this paper generally indicates that the associated objects with this character are in an "or" relationship.

In the description of the embodiments of the present disclosure, the phase "multiple" or "plurality of" refers to two or more (including two). Similarly, "multiple groups" or "plurality of groups" refers to two or more groups (including two groups), and "multiple pieces" or "plurality of pieces" refers to two or more pieces (including two pieces).

In the description of the embodiments of the present disclosure, the technical terms "center", "longitudinal", "lateral", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc., indicate the orientation or positional relationship based on the orientation or positional relationship shown in the accompanying drawings. This is solely for the purpose of facilitating the description of the embodiments of the present disclosure and simplifying the description, and in no way indicate or imply that the devices or elements referred to must have a specific orientation, be constructed or operated in a specific orientation. Therefore, these terms should not be construed as a limitation on the embodiments of the present disclosure.

In the description of the embodiments of the present disclosure, unless otherwise explicitly specified and defined, the technical terms such as "installation", "connection", "fixation", etc. should be understood in a broad sense. For example, "connection" may refer to fixed connection, detachable connection, or integral connection; mechanical connection or electrical connection; direct connection, or indirect connection through an intermediary. It may further refer to the internal connectivity between two components or the interaction between two components. For those of ordinary skill in the art, the specific meanings of the above terms in embodiments of the present disclosure should be understood according to the specific circumstances.

In the drawings corresponding to the embodiments of the present disclosure, the thickness and area of the layers have been exaggerated for better understanding and ease of description. When a component (such as a layer, film, region, or substrate) is described as being on another component or on the surface of another component, the component may be "directly" located on the surface of the another component, or a third component may exist between the two components. On the contrary, when one component is described as being at the surface of another component, or when it recites that one component's surface forms or is provided with another component, it indicates that there is no third component between the two components. In addition, when it recites that a component is "roughly" formed on another component, it means that this component is not formed on the entire surface (or front surface) of the another component, nor is it formed on a portion of the edge of the entire surface.

In the description of the embodiments of the present disclosure, when it recites that one component "includes" another component, it does not exclude other components and other components may also be further included unless otherwise stated. In addition, when a component such as a layer, film, region, or plate is referred to as being "on/located on" another component, it can either be "directly on" the another component (i.e., located on the surface of the another component without any other components in between), or yet another component may exist between them. In addition, when a component such as a layer, film, region, or plate is referred to as being "directly located on" another component, or when a component such as a layer, film, region, or plate is referred to as being located on the surface of another component, it indicates that no other components are located between them.

The terms used in the description of various embodiments mentioned in this paper are solely for the purpose of describing specific embodiments and are not intended to be restrictive. As used in the description of the various embodiments and the appended claims, "component" is also intended to cover the plural form, unless the context clearly indicates otherwise. Among them, components include layers, films, regions, or plates.

The following provides a detailed description of the various embodiments of the present disclosure in conjunction with the accompanying drawings. However, those of ordinary skill in the art may understand that in various embodiments of the present disclosure, many technical details have been presented to facilitate a better understanding of the present disclosure by the reader. However, even without these technical details and the various variations and modifications based on the following embodiments, the technical solution claimed in the present disclosure can still be achieved.

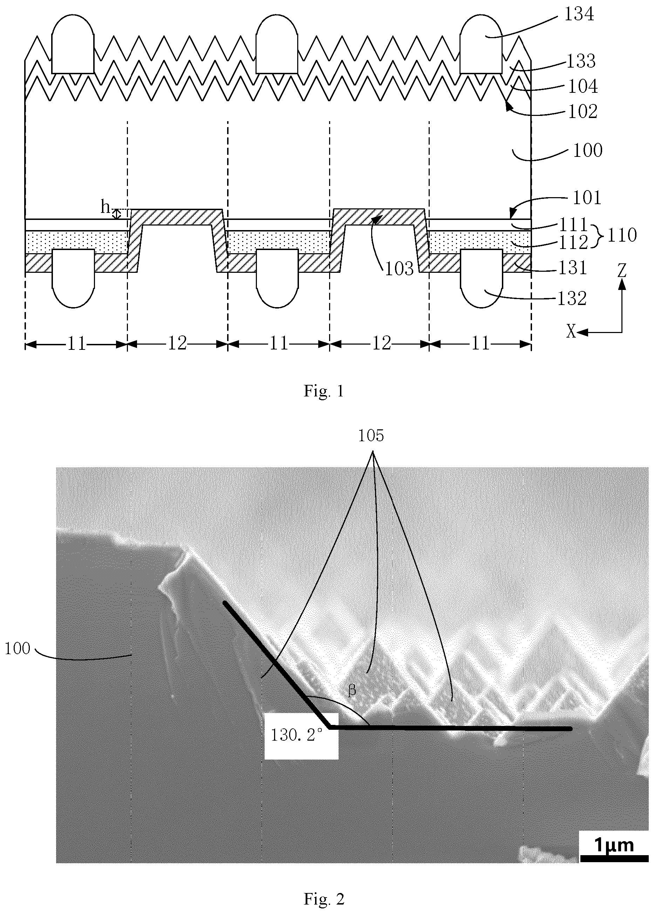

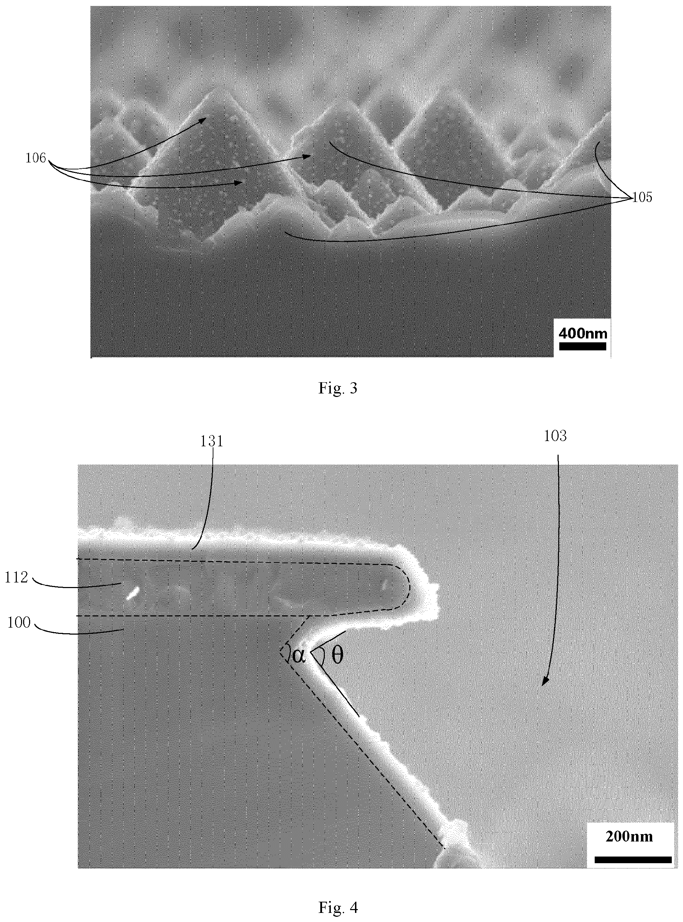

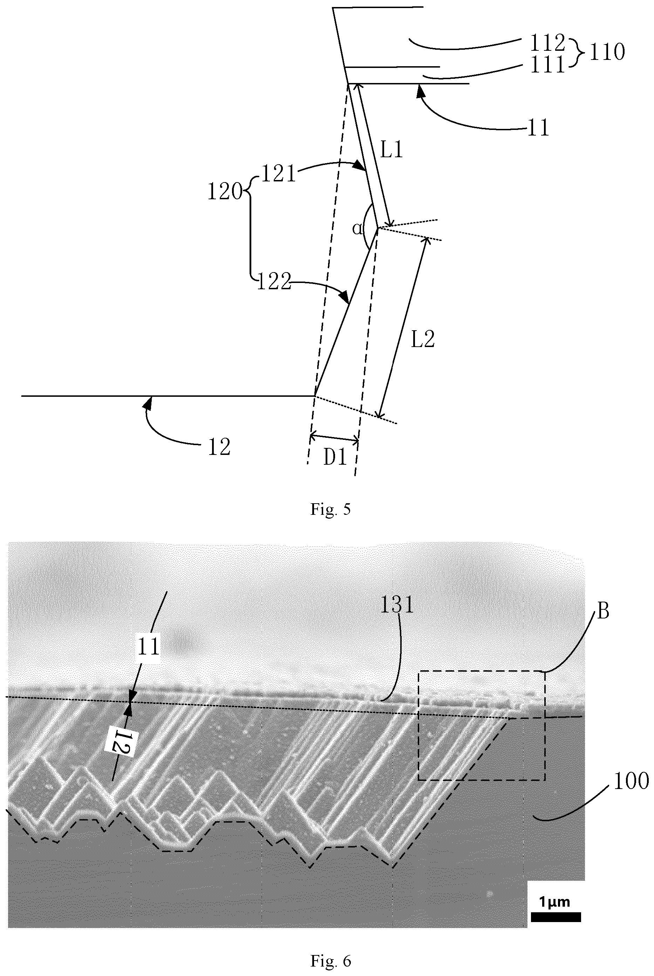

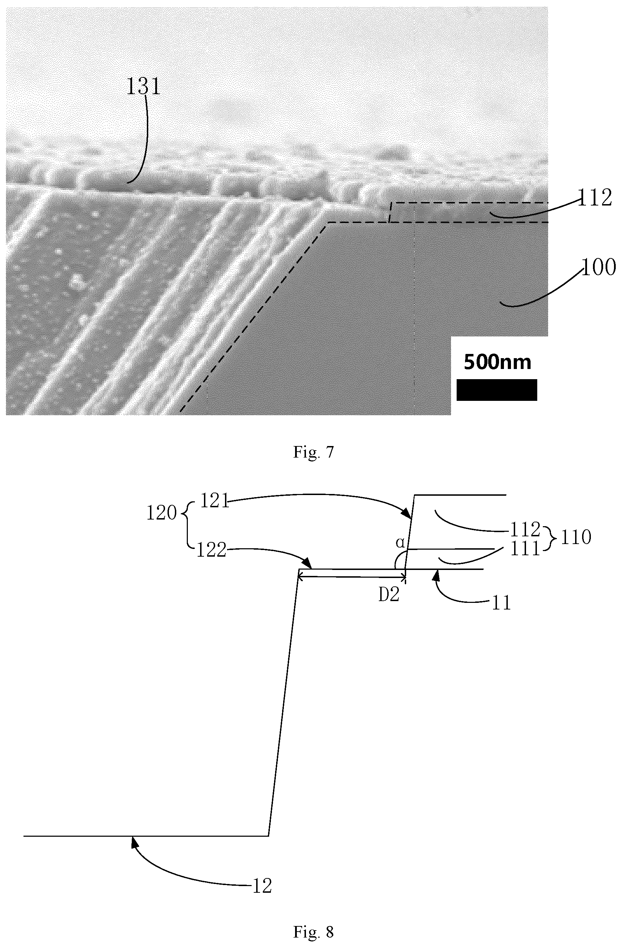

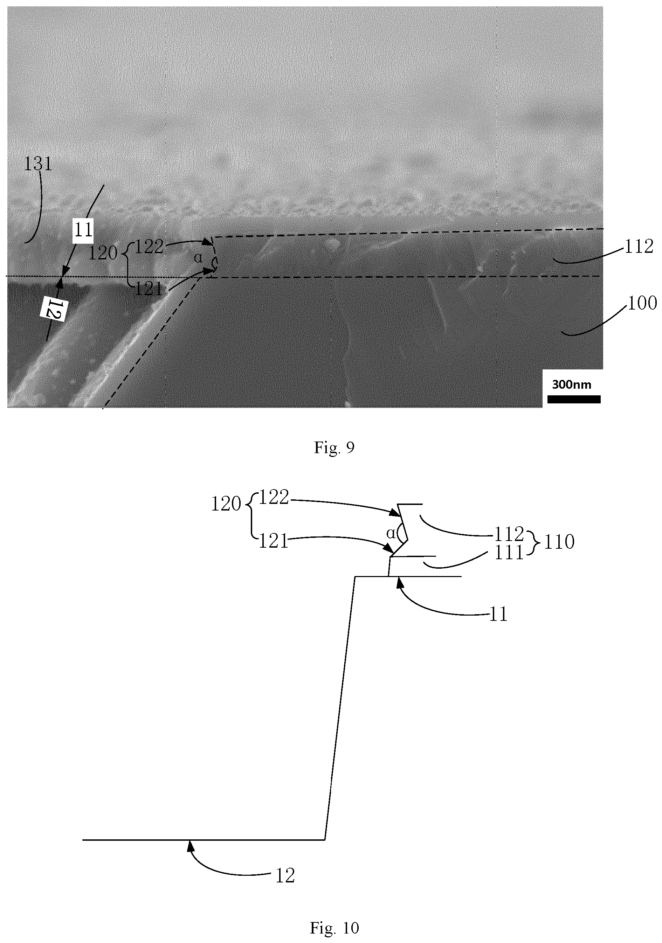

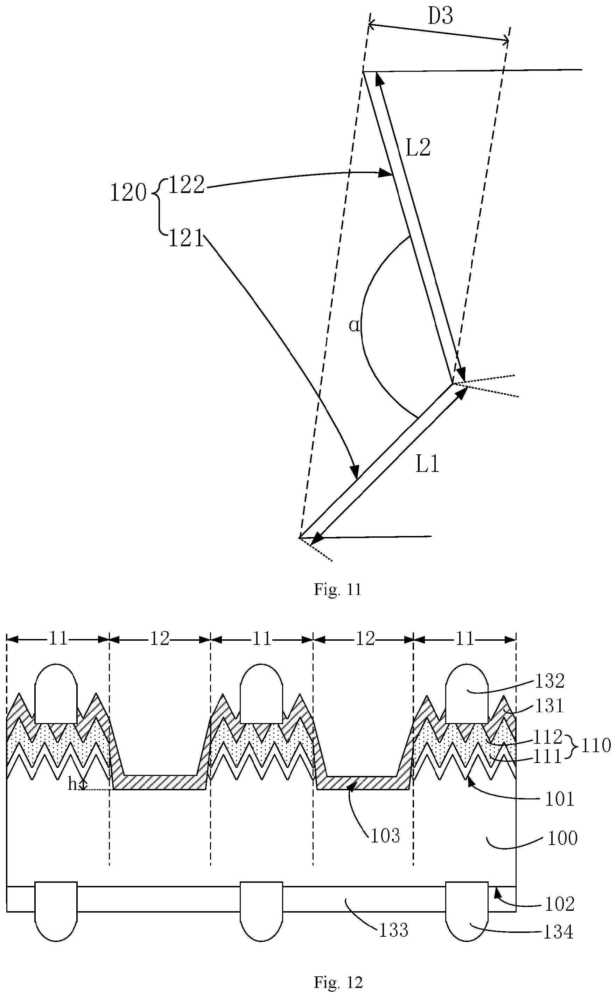

Fig. 1 is a cross-sectional view of a solar cell according to an embodiment of the present disclosure; Fig. 2 is a scanning electron microscope (SEM) image of the junction between one first region and one second region in the solar cell according to an embodiment of the present disclosure; Fig. 3 is a partial enlarged view of the second region in Fig. 2; Fig. 4 is another SEM image of the junction between the first region and the second region in the solar cell according to an embodiment of the present disclosure; Fig. 5 is a partial enlarged view of the recess in Fig. 4; Fig. 6 is yet another SEM image of the junction between the first region and the second region in the solar cell according to an embodiment of the present disclosure; Fig. 7 is a partial enlarged view of portion B in Fig. 6; Fig. 8 is a partial enlarged view of the recess in Fig. 6; Fig. 9 is a further SEM image of the junction between the first region and the second region in the solar cell according to an embodiment of the present disclosure; Fig. 10 is a partial enlarged view of the junction in Fig. 9; Fig. 11 is a partial enlarged view of the recess in Fig. 10.

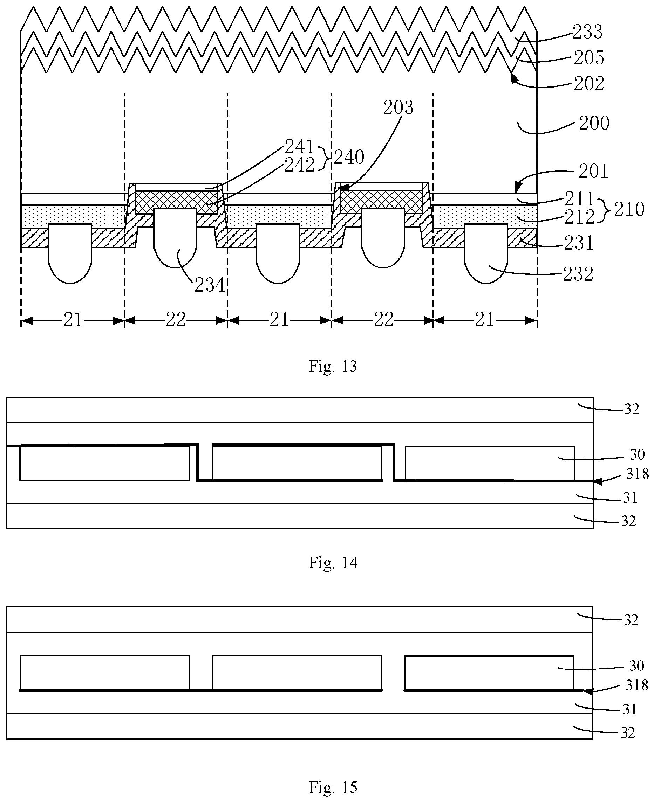

It should be noted that Figs. 2 to 4, 6 to 7, and 9 are scanning electron microscope images of the solar cell, with dashed lines indicating the boundaries between distinct film layers. A scanning electron microscope (SEM) image is formed by scanning a finished solar cell with a scanning electron microscope and generating physical signals. The generated physical signals are then converted into image information by a detector. The solar cell shown in Fig. 1, as well as subsequent Fig. 12 and Fig. 13, are exemplified with the side facing up as the front side and the side facing down as the rear side.

According to some embodiments of the present disclosure, the embodiments of the present application provide a solar cell on the one hand, for improving the photoelectric conversion efficiency of the solar cell. Referring to Fig. 1, Fig. 5, Fig. 8, and Fig. 10, the solar cell includes: a substrate 100. The substrate 100 has a first surface 101 and a second surface 102 opposite to the first surface. The first surface 101 has first regions 11 and second regions 12 alternatingly arranged thereon. The second regions 12 are grooves 103 with respect to the first regions 11. The solar cell further includes a passivation contact structure 110 located at least over the first regions 11. The passivation contact structure 110 has a first side surface abutting one of the grooves 103, the one of the grooves 103 has a second side surface connected to the first side surface, one of the first side surface and the second side surface has a recess 120 recessed inward along a first direction X. The recess 120 includes a first facet 121 and a second facet 122 connected to the first facet. The first facet 121 is connected to an adjacent first region 11, and a first obtuse angle α is formed between the first facet 121 and the second facet 122. The first direction X is a direction pointing from a respective second region 12 towards an adjacent first region 11. The solar cell further includes a passivation layer 131 formed over the passivation contact structure 110 and the grooves 103. The solar cell further includes a first electrode 132 arranged on the passivation layer 131 and electrically connected to the passivation contact structure 110.

In the solar cell provided by the embodiments of the present disclosure, the second regions 12 are grooves 103 with respect to the first regions 11, forming an uneven surface of the substrate 100. The unevenness formed by the first regions 11 and the recessed second regions 12 enhances the internal reflection of incident light. The passivation contact structure 110 is locally confined to the first regions 11 (and absent in the second regions 12), with the first electrode 132 disposed on the first regions 11, forming a localized passivation structure. The localized passivation design leverages the high doping concentration of the passivation contact structure 110 to reduce contact resistance, avoids adverse effects from excessive doping and minimizes optical losses inherent to the passivation contact structure 110 itself. The passivation contact structure 110 has a first side surface abutting one of the grooves 103, the one of the grooves 103 has a second side surface connected to the first side surface, one of the first side surface and the second side surface has a recess 120 recessed inward along the first direction X. The recess 120 resembles an inverted pyramid structure and functions as a light-trapping structure, which can enhance the internal reflection rate of the solar cell and improve the photoelectric conversion efficiency.

In some embodiments, the material of the substrate 100 may be a material of an element semiconductor. Specifically, the material of an element semiconductor consists of a single element, such as silicon or germanium. The material of an element semiconductor may exist in single crystal, polycrystalline, amorphous, or microcrystalline states (which has both the single crystal state and the amorphous state). For instance, silicon may be at least one of single crystal silicon, polycrystalline silicon, amorphous silicon, or microcrystalline silicon.

In some embodiments, the material of the substrate 100 may be a material of a compound semiconductor. The material of a common compound semiconductor includes, but is not limited to, silicon germanide, silicon carbide, gallium arsenide, gallium indium compound, perovskite, cadmium telluride, and copper indium selenide. The substrate 100 may also be a sapphire substrate 100, a silicon substrate 100 on insulator, or a germanium substrate 100 on insulator.

In some embodiments, the substrate 100 may be an N-type semiconductor substrate 100 or a P-type semiconductor substrate 100. The N-type semiconductor substrate 100 is doped with an N-type doping element, which may be any one of the group 5 elements such as phosphorus (P), bismuth (Bi), antimony (Sb), or arsenic (As). The P-type semiconductor substrate 100 is doped with a P-type element, which may be any one of the group 3 elements such as boron (B), aluminum (Al), gallium (Ga), or indium (In).

In some embodiments, taking the solar cell shown in Fig. 1 as an example, the first surface 101 is the rear surface, and the second surface 102 is the front surface. The terms "front" and "rear" are relative terms. Specifically, "front" refers to the surface facing sunlight along the vertical direction, and "rear" refers to the surface opposite to sunlight along the vertical direction. In other embodiments, such as the solar cell shown in Fig. 12, the first surface 101 is the front surface, and the second surface 102 is the rear surface. Detailed descriptions will be provided later with reference to Fig. 12.

In some embodiments, the solar cell is a monofacial cell, with the front surface serving as a light-receiving surface to receive incident light, and the rear surface serving as a back surface. The back surface can also receive incident light, but the efficiency of receiving incident light of the back surface is lower than that of the light-receiving surface.

In some embodiments, the solar cell is a bi-facial cell, with the front and rear surfaces of the substrate 100 both serving as light-receiving surfaces to receive incident light.

In some embodiments, the first regions 11 refer to the regions where the orthographic projections of first electrodes 132 on a reference plane are located, and serves as functional regions for forming first-type metal electrodes; the second regions 12 refer to the regions of the substrate 100 excluding the first regions 11, that is, the regions outside the orthographic projections of the first electrodes 132 on the reference plane.

It should be noted that to ensure that the film layers contacted by the first electrode 132 are all corresponding functional film layers, the range of the first region 11 is set to be greater than or equal to the orthogonal projection range of the first electrode 132 on the reference plane, that is, any orthogonal projection of the first electrode 132 on the reference plane is located within the first region 11, and the distance between the edge of the first region 11 and the edge of the orthogonal projection is greater than or equal to 0. The reference plane is a flat surface perpendicular to a thickness direction Z of the substrate 100. The reference plane is parallel to the plane containing the first direction X and perpendicular to the thickness direction Z of the substrate 100.

In addition, the first regions 11 and the second regions 12 are designated regions for functional zoning of the substrate 100 (or the first surface 101) to illustrate the distribution of various film layers of the solar cell. Both the first regions 11 and the second regions 12 actually belong to the substrate 100 (or the first surface 101), and there is no physical boundary between different regions, but the film layers residing on different regions may be different. For example, a first passivation contact structure and the first electrode 132 reside on the first region 11, while the passivation layer 131 resides on the second region 12.

In some embodiments, referring to Fig. 1, the difference between the first distance and the second distance is less than or equal to 5 µm, that is, the depth h of the groove 103 is less than or equal to 5 µm. Thus, the first surface 101 of the substrate 100 is a rough surface with grooves. Provision of grooves 103 increases the refractive index of incident light, thereby improving the photoelectric conversion efficiency of the back contact solar cell. Furthermore, the depth h of the groove 103 ranges from 0.5 µm to 1.5 µm. This depth range ensures controlled etching depth of the substrate 100. The first passivation contact structure 110 on the second regions 12 can be fully etched while minimizing excessive etching of the substrate 100, thereby avoiding adverse effects caused by over-etching of the substrate 100. It reduces the etching time and the amount of etching solution required for etching the substrate 100, lowering manufacturing costs.

Specifically, the depth h of the groove 103 may be 0.5 µm, 0.8 µm, 1.2 µm, 1.5 µm, 2.3 µm, 2.6 µm, 3.1 µm, 3.8 µm, 4.2 µm, 4.5 µm, or 4.9 µm.

In some embodiments, a third obtuse angle β is formed between a bottom surface of the groove 103 and a side surface of the groove 103, and the third obtuse angle β ranges from 110 ° to 150 °. Thus, an obtuse angle is formed between the bottom surface of groove 103 and its side surface, with the side surface of the groove 103 inclined relative to its bottom surface, thereby enhancing the internal reflection rate of incident light.

The third obtuse angle β between the bottom surface of the groove 103 and its side surface may be 110 °, 115 °, 120 °, 125 °, 130 °, 135 °, 140 °, 145 °, or 150 °. For example, the angle β shown in Fig. 2 is 130.2 °.

In some embodiments, referring to Fig. 2, inner wall surfaces of the grooves 103 have micro-textured structures 105 including pyramidal structures, quasi-pyramidal structures, prismatic structures, or quasi-prismatic structures. The dimensions of the micro-textured structures 105 are less than or equal to 2 µm. The dimensions refer to the base length and the height of the cross-section. The micro-textured structures can enhance the internal reflection rate of incident light, reduce optical losses, and thereby improve the photoelectric conversion efficiency.

Referring to Fig. 3, the subsequent film layers formed on the micro-textured structures, such as the passivation layer 131 covering the micro-textured structures, do not completely fill the gaps among the micro-textured structures, and the outermost surface still exhibits a micro-textured structure.

In some embodiments, the passivation contact structure 110 includes a tunneling dielectric layer 111 and a doped semiconductor layer 112. The tunneling dielectric layer 111 is located on the first regions 11, the doped semiconductor layer 112 is located on a surface of the tunneling dielectric layer 111, and the passivation layer 131 is located on a surface of the doped semiconductor layer 112. The first electrode 132 is electrically connected to the doped semiconductor layer 112.

The doped semiconductor layer 112 induces band bending at the surface of the substrate 100. The tunneling dielectric layer 111 causes an asymmetric offset in the surface band structure of the substrate 100, resulting in a lower potential barrier for majority carriers compared to minority carriers. Consequently, majority carriers can more easily undergo quantum tunneling through the tunneling dielectric layer 111, while minority carriers are largely blocked, thereby enabling selective carrier transport.

Additionally, the tunneling dielectric layer 111 provides chemical passivation. Specifically, interface state traps at the boundary between the substrate 100 and the tunneling dielectric layer 111 lead to a high interface state density on the first surface 101. Increased interface state density promotes carrier recombination. The tunneling dielectric layer 111 is arranged on the first surface 101, enabling it to chemically passivate the surface of the substrate 100. By saturating the dangling bonds of the substrate 100, the trap state density of the substrate 100 is decreased, and the recombination centers of the substrate 100 are decreased, thereby lowering the carrier recombination rate.

The doped semiconductor layer 112 further provides field passivation. An electrostatic field directed towards the interior of the substrate 100 is formed on its surface. This field drives minority carriers to escape away from the interface, reducing the concentration of minority carriers. The decreased minority carrier concentration suppresses recombination at the interface of the substrate 100, thereby increasing the open-circuit voltage, short-circuit current, and fill factor of the back contact solar cell, and enhancing its photoelectric conversion efficiency.

In some embodiments, the thickness of the tunneling dielectric layer 111 ranges from 0.5 nm to 10 nm. The thickness range of the tunneling dielectric layer 111 may be 0.5 nm to 1.3 nm, 1.3 nm to 4.6 nm, 4.6 nm to 6.1 nm, or 6.1 nm to 10 nm. If the thickness of the tunneling dielectric layer 111 falls within any of the aforementioned ranges, the tunneling dielectric layer 111 is thin enough that majority carriers can easily undergo quantum tunneling through the tunneling dielectric layer 111, while minority carriers are largely blocked, thereby enabling selective carrier transport.

In some embodiments, the material of the tunneling dielectric layer 111 includes at least one of silicon oxide, amorphous silicon, microcrystalline silicon, nanocrystalline silicon, and silicon carbide.

In some embodiments, the doped semiconductor layer 112 includes at least one of doped amorphous silicon layer, doped polysilicon layer, doped microcrystalline silicon layer, doped silicon carbide layer, and doped crystalline silicon layer.

The side surface of the groove 103 or the passivation contact structure 110 is provided with the recess 120. The recess 120 resembles an inverted pyramid structure and functions as a light-trapping structure, which can enhance the internal reflection rate of the solar cell and improve the photoelectric conversion efficiency.

In some embodiments, referring to Fig. 4, Fig. 6, or Fig. 9, the first obtuse angle α ranges from 100 ° to 140 °. When the first obtuse angle α falls within the aforementioned range, the depth of the resulting light-trapping structure is relatively small, avoiding excessive etching to the substrate 100. The first obtuse angle α may be 100 °, 105 °, 110 °, 115 °, 120 °, 125 °, 130 °, 135 °, or 140 °.

The recess 120 may be located on the side surface of the substrate 100 as shown in Fig. 4, on the side surface of the N-type doped semiconductor layer 112 as shown in Fig. 6, or on the side surface of the P-type doped semiconductor layer 112 as shown in Fig. 9. The following will explain three different structures in conjunction with the accompanying drawings.

First type: As shown in Fig. 4, the recess 120 is located on the side surface of the substrate 100. Referring to Fig. 5, the first facet 121 is connected to an adjacent first region 11, and the second facet 122 is connected to an adjacent second region 12. The first length of the first facet 121 is less than the second length of the second facet 122. Thus, by positioning the recess 120 close to the passivation contact structure and leveraging the inclined side surface of the groove 103, the passivation layer 131 deposited within the recess 120 achieves a greater thickness, while the passivation layer 131 deposited on the passivation contact structure 110 maintains a moderate thickness, so that the passivation layer 131 can form effective passivation on the recess 120 and additional passivation coverage on the side surface of the passivation contact structure 110.

In some embodiments, the ratio of the length of the second facet 122 to the length of the first facet 121 ranges from 8 to 30. The ratio of the length of the second facet 122 to the length of the first facet 121 may be 8, 10, 12, 14, 16, 18, 20, 22, 24, 26, 28, or 30.

In some embodiments, the first length L1 of the first facet 121 ranges from 50 nm to 400 nm. The first length L1 of the first facet 121 may be 50 nm, 100 nm, 150 nm, 200 nm, 250 nm, 300 nm, 350 nm, or 400 nm.

In some embodiments, the second length L2 of the second facet 122 ranges from 0.5 µm to 3 µm. The second length L2 of the second facet 122 may be 0.5 µm, 0.8 µm, 1.2 µm, 1.5 µm, 1.8 µm, 2.1 µm, 2.3 µm, 2.5 µm, 2.8 µm, or 3 µm.

In some embodiments, a depth of the recess 120 along the first direction is less than or equal to 200 nm. That is, the first depth D1 of the recess 120 along the first direction is less than or equal to 200 nm. The depth of the recess 120 is moderate, avoiding excessive etching to the substrate 100. The depth of the recess 120 along the first direction may be 50 nm, 70 nm, 90 nm, 110 nm, 130 nm, 150 nm, 180 nm, or 200 nm.

It should be noted that the first depth shown in Fig. 5 is not exactly parallel to the first direction (refer to Fig. 1). In practice, the first depth of the recess 120 along the first direction is approximately the same as the first depth D1 shown in Fig. 5.

Second type: As shown in Fig. 6, the recess 120 is located on a side surface of an N-type doped semiconductor layer 112. Referring to Fig. 8, the first facet 121 is connected to an adjacent first region 11, and the second facet 122 is connected to a side surface of an adjacent groove 103. The first length of the first facet 121 is less than the second length of the second facet 122.

In some embodiments, the doped semiconductor layer 112 is doped with an N-type doping element, and the depth of the recess 120 along the first direction is less than or equal to 800 nm. Referring to Fig. 8, the second depth D2 of the recess 120 along the first direction is less than or equal to 800 nm. The second depth D2 of the recess 120 along the first direction may be 50 nm, 100 nm, 200 nm, 300 nm, 400 nm, 500 nm, 600 nm, 700 nm, or 800 nm.

In some embodiments, the ratio of the length of the second facet 122 to the length of the first facet 121 ranges from 8 to 30. The ratio of the length of the second facet 122 to the length of the first facet 121 may be 8, 10, 12, 14, 16, 18, 20, 22, 24, 26, 28, or 30.

The third type: As shown in Fig. 9, the recess 120 is located on a side surface of a P-type doped semiconductor layer 112. Referring to Fig. 10, the first facet 121 is connected to an adjacent first region 11 through a side surface of the tunneling dielectric layer 111, and the second facet 122 is connected to a top surface of the doped semiconductor layer 112. The first length of the first facet 121 is less than the second length of the second facet 122.

In some embodiments, the ratio of the length of the second facet 122 to the length of the first facet 121 ranges from 8 to 30. The ratio of the length of the second facet 122 to the length of the first facet 121 may be 8, 10, 12, 14, 16, 18, 20, 22, 24, 26, 28, or 30.

In some embodiments, the first length L1 of the first facet 121 ranges from 1 nm to 100 nm. The first length L1 of the first facet 121 may be 1 nm, 10 nm, 30 nm, 35 nm, 60 nm, 70 nm, 85 nm, or 100 nm.

In some embodiments, referring to Fig. 11, the second length L2 of the second facet 122 ranges from 10 nm to 200 nm. The second length L2 of the second facet 122 may be 10 nm, 40 nm, 80 nm, 120 nm, 160 nm, 170 nm, 185 nm, or 200 nm.

In some embodiments, a depth of the recess 120 along the first direction is less than or equal to 200 nm. That is, the third depth D3 of the recess 120 along the first direction is less than or equal to 200 nm. The depth of the recess 120 is moderate, avoiding excessive etching to the substrate 100. The depth of the recess 120 along the first direction may be 50 nm, 70 nm, 90 nm, 110 nm, 130 nm, 150 nm, 180 nm, or 200 nm.

It should be noted that the first depth shown in Fig. 11 is not exactly parallel to the first direction (refer to Fig. 1). In practice, the third depth of the recess 120 along the first direction is approximately the same as the third depth D3 shown in Fig. 11.

In some embodiments, referring to Fig. 4 or Fig. 9, the doped semiconductor layer 112 is doped with a P-type doping element, where the doped semiconductor layer 112 includes a first portion (not labeled) and a second portion (not labeled) connected to the first portion, the first portion is located on the tunneling dielectric layer 111, the second portion extends along an end of the first portion to an adjacent groove 103, and the recess 120 is formed on a side surface of the second portion. Thus, the doped semiconductor layer 112 protrudes from the substrate 100 and is located above the groove 103. Based on the structure of the doped semiconductor layer 112, a third light-trapping structure is formed between the doped semiconductor layer 112 and the substrate 100 to increase internal reflection.

In some embodiments, a length of the second portion along the first direction is less than or equal to 1 µm. The length of the second portion may be 0.01 µm, 0.05 µm, 0.11 µm, 0.3 µm, 0.6 µm, 0.8 µm, or 1 µm.

In some embodiments, referring to Fig. 4, the passivation layer 131 covers the first facet 121 and the second facet 122, where the passivation layer 131 has a third side surface (not labeled) and a fourth side surface (not labeled), the third side surface corresponds to the first facet 121, the fourth side surface corresponds to the second facet 122, a second obtuse angle θ is formed between the third side surface and the fourth side surface, and the second obtuse angle θ is less than or equal to the first obtuse angle. As such, the passivation layer 131 deposited within the recess 120 has a greater thickness, thereby forming effective passivation on the substrate 100.

Referring to Fig. 3, the surface of the passivation layer has agglomerates 106, which can enhance the internal reflection rate.

In some embodiments, the second surface 102 has a textured structure (not shown) which includes multiple pyramidal structures. The solar cell further includes an emitter layer 104 covering the textured structure. The emitter layer 104 is doped with a doping element of a conductivity type different from that of the substrate 100. For example, if the substrate 100 is doped with an N-type doping element, the emitter layer is doped with a P-type doping element. The solar cell further includes: a second passivation layer 133 covering the emitter layer.

In some embodiments, the second passivation layer 133 may be a single-layer structure or a stacked structure. The material of the second passivation layer 133 may include one or more of silicon oxide, silicon nitride, silicon oxynitride, silicon carbon oxynitride, titanium oxide, hafnium oxide, and aluminum oxide.

In some embodiments, the material of the second passivation layer 133 is the same as that of the passivation layer 131, and the second passivation layer 133 and the passivation layer 131 are prepared in the same preparation process.

Referring further to Fig. 1, in some embodiments, the solar cell further includes: a second electrode 134 arranged on the second surface 102 and electrically connected to the emitter layer 104.

In some embodiments, either of the first electrode 132 or the second electrode 134 may be formed by sintering a fire-through metal paste or a laser-enhanced contact optimization (LECO) paste. The metal paste and LECO paste may include at least one of silver, aluminum, copper, tin, gold, lead, or nickel.

It should be noted that the configuration shown in Fig. 1 where the first electrode 132 penetrates through the passivation layer 131 and electrically contacts the doped semiconductor layer 112, and the second electrode 134 penetrates through the second passivation layer 133 and electrically contacts the emitter layer 104, is provided solely as an exemplary illustration. In practical back contact solar cells, the connection between the first electrode 132 and the doped semiconductor layer 112 may be a direct electrical contact or an indirect connection via conductive particles. Similarly, the connection between the second electrode 134 and the emitter layer 104 may also be a direct electrical contact or an indirect connection via conductive particles. The conductive particles may include silver crystals, silver agglomerates, silver particles, or other conductive metal particles.

Fig. 12 is a cross-sectional view of another solar cell according to an embodiment of the present disclosure.

Referring to Fig. 12, the first surface 101 of the substrate 100 is the front surface, and the second surface 102 of the substrate 100 is the rear surface. The doping element in the doped semiconductor layer 112 of the passivation contact structure 110 is of a different conductivity type from the doping element in the substrate 100. The first surface 101 of the substrate 100 has a textured structure (not labeled) which includes multiple pyramidal structures.

The rear surface of the substrate 100 has a second passivation layer 133 covering the second surface 102 of the substrate 100, and the second electrode 134 is in contact with the surface of the substrate 100.

In the solar cell provided by the embodiments of the present disclosure, the second regions 12 are grooves 103 with respect to the first regions 11, forming an uneven surface of the substrate 100. The unevenness formed by the first regions 11 and the recessed second regions 12 enhances the internal reflection of incident light. The passivation contact structure 110 is locally confined to the first regions 11 (and absent in the second regions 12), with the first electrode 132 disposed on the first regions 11, forming a localized passivation structure. The localized passivation design leverages the high doping concentration of the passivation contact structure 110 to reduce contact resistance, avoids adverse effects from excessive doping and minimizes optical losses inherent to the passivation contact structure 110 itself. The passivation contact structure 110 has a first side surface abutting one of the grooves 103, the one of the grooves 103 has a second side surface connected to the first side surface, one of the first side surface and the second side surface has a recess 120 recessed inward along the first direction X. The recess 120 resembles an inverted pyramid structure and functions as a light-trapping structure, which can enhance the internal reflection rate of the solar cell and improve the photoelectric conversion efficiency.

Correspondingly, another embodiment of the present disclosure provides a solar cell which is a back contact solar cell. The aforementioned groove and recess may also be formed at the junction between the P-type region and the N-type region. Differences from the previous embodiment will be elaborated in detail below, while identical features may be referenced to the solar cell shown in Fig. 1 of the previous embodiment.

Fig. 13 is a cross-sectional view of the solar cell according to another embodiment of the present disclosure.

Referring to Fig. 13, the back contact cell includes: a substrate 200. The substrate 200 has a first surface 201 and a second surface 202 opposite to the first surface. The first surface 201 has first regions 21 and second regions 22 alternatingly arranged thereon. The second regions 22 are grooves 203 with respect to the first regions 21. The solar cell further includes a passivation contact structure 210 located at least over the first regions 21. The passivation contact structure 210 has a first side surface abutting one of the grooves 203, the one of the grooves 203 has a second side surface connected to the first side surface, one of the first side surface and the second side surface has a recess recessed inward along a first direction X. The recess includes a first facet and a second facet connected to the first facet. The first facet is connected to an adjacent first region 21, and a first obtuse angle is formed between the first facet and the second facet. The first direction X is a direction pointing from the second region 22 towards the first region 21. The solar cell further includes a passivation layer 231 formed over the passivation contact structure 210 and the grooves 203. The solar cell further includes a first electrode 232 arranged on the passivation layer 231 and electrically connected to the passivation contact structure 210.

In some embodiments, the first regions 21 refer to the regions where the orthographic projections of first electrodes 232 on a reference plane are located, and serves as functional regions for forming first-type metal electrodes. Similarly, the second regions 22 refer to the regions where the orthographic projections of second electrodes 234 on the reference plane are located, and serves as functional regions for forming second-type metal electrodes.

In some embodiments, there is a gap region (also known as non-metal electrode region) between adjacent first region 21 and second region 22. The gap region refers to the non-overlapping region between the orthographic projection of the first electrode 232 and the orthographic projection of the second electrode 234 on the reference plane. That is, the gap region serves as a functional region where no metal electrodes are formed. In other embodiments, there is no gap region between adjacent first region 21 and second region 22, but there is a height difference between them. The film layer located on the first region 21 does not contact the film layer located on the second region 22.

In addition, the first regions 21, the second regions 22, and the gap regions are designated regions for functional zoning of the substrate 200 (or the first surface 201) to illustrate the distribution of various film layers of the solar cell. All three regions actually belong to the substrate 200 (or the first surface 201), and there is no physical boundary between different regions, but the film layers residing on different regions may be different.

In some embodiments, the solar cell further includes: a second passivation contact structure 240, where the second passivation contact structure 240 is located in the second regions 22, and the passivation layer 231 covers the second passivation contact structure 240; a second electrode 234, located on the second regions 22 and electrically connected to the second passivation contact structure 240.

In some embodiments, the second passivation contact structure 240 includes a second tunneling dielectric layer 241 and a second doped semiconductor layer 242. The second tunneling dielectric layer 241 is located on the second regions, the second doped semiconductor layer 242 is located on a surface of the second tunneling dielectric layer 241, and the passivation layer 231 is located on a surface of the second doped semiconductor layer 242. The second electrode 234 is electrically connected to the second doped semiconductor layer 242.

The function, material, and thickness configuration of the second tunneling dielectric layer 241 may be referenced to the description of the aforementioned tunneling dielectric layer 111. The function and material configuration of the second doped semiconductor layer 242 may be referenced to the description of the aforementioned doped semiconductor layer 112.

The difference between the doped semiconductor layer 212 and the second doped semiconductor layer 242 lies in: the doped semiconductor layer 212 is one of N-type doped layer and P-type doped layer; while the second doped semiconductor layer 242 is the other of N-type doped layer and P-type doped layer.

Referring to Fig. 13, the second surface of the substrate has a surface field 205 and a second passivation layer 233 covering the surface field 205.

It should be noted that the side surfaces of the grooves and the passivation contact structure shown in Fig. 13 also have the recesses described in the aforementioned embodiment. Depending on the type of the doping element in the doped semiconductor layer, the structure may vary. For specific details, reference may be made to the description of the recesses in the previous embodiment, which will not be repeated here. The relevant contents of the substrate 200, passivation contact structure 210, tunneling dielectric layer 211, doped semiconductor layer 212, groove 203, and first electrode 232 shown in Fig. 13 may be referenced to the substrate 100, passivation contact structure 110, tunneling dielectric layer 111, doped semiconductor layer 112, groove 103, and first electrode 132 in the previous embodiment.

Some embodiments of the present disclosure provide a tandem cell, including: a bottom cell, which is the solar cell according to any one of the aforementioned embodiments; and a top cell, disposed on a rear side of the substrate of the bottom cell.

In some embodiments, the tandem cell includes a first grid line of a first polarity and a second grid line of a second polarity. When the bottom cell is the solar cell shown in Fig. 1, the first grid line refers to the second electrode of the solar cell, and the second grid line refers to the electrode of the top cell. When the bottom cell is the solar cell shown in Fig. 12, the first grid line refers to the first electrode of the solar cell, and the second grid line refers to the electrode of the top cell. When the bottom cell is the solar cell shown in Fig. 13, the first grid line refers to the first electrode of the back contact solar cell, and the second grid line refers to the second electrode of the back contact solar cell.

In some embodiments, there is an interface layer between the top cell and the bottom cell, and the interface layer covers the passivation contact structure on the rear side.

It should be noted that the tandem cell in the embodiments of the present disclosure may be a two-layer solar cell, a three-layer solar cell, or a tandem cell with more than three layers.

In some embodiments, the top cell may be a perovskite solar cell including the following stacked layers: a first transport layer, a perovskite substrate, a second transport layer, a transparent conductive layer, and an antireflection layer. The first transport layer is adjacent to the bottom cell.

In some embodiments, the first transport layer may be one of electron transport layer and hole transport layer, and the second transport layer may be the other of electron transport layer and hole transport layer.

Some embodiments of the present disclosure further provide a photovoltaic module. Referring to Fig. 14 or Fig. 15, the photovoltaic module includes: a cell string, formed by connecting multiple solar cells 30 as described in previous embodiments; an encapsulation film 31, configured for covering a surface of the cell string; and a cover plate 32, configured for covering a surface of the encapsulation film 31 away from the cell string. Fig. 14 is a cross-sectional view of a photovoltaic module according to an embodiment of the present disclosure; and Fig. 15 is another cross-sectional view of the photovoltaic module according to an embodiment of the present disclosure.

The photovoltaic module shown in Fig. 15 further includes connecting components 318 configured for electrically connecting two adjacent solar cells 30. Specifically, in some embodiments, multiple solar cells 30 can be electrically connected through connecting components 318, and the connecting components 318 are welded to the busbars/fingers on the solar cells 30.

In some embodiments, the connecting component 318 is welded to the finger on the cell, and the finger includes the first electrode and the second electrode. In some embodiments, the connecting component 318 is welded to the busbar on the cell. The busbar includes a first busbar and a second busbar. The first busbar is welded to the first electrode, and the second busbar is welded to the second electrode.

In some embodiments, the encapsulation film 31 includes a first encapsulation film and a second encapsulation film. The first encapsulation film covers one of the front surface and the back surface of the back contact solar cell, while the second encapsulation film covers the other. Specifically, at least one of the first encapsulation film and the second encapsulation film may be an organic encapsulation film such as polyvinyl butyral (PVB) film, ethylene-vinyl acetate copolymer (EVA) film, polyethylene octene elastomer (POE) film, or polyethylene terephthalate (PET) film.

It will be appreciated that the first encapsulation film and the second encapsulation film have a boundary before lamination. After the lamination process, the boundary between the first encapsulation film and the second encapsulation film of the photovoltaic module no longer exists, as the first encapsulation film and the second encapsulation film have become an integral encapsulation film 31.

In some embodiments, the cover plate 32 may be a glass cover plate, a plastic cover plate, or any other cover plate with a light-transmitting function. Specifically, a surface, facing towards the encapsulation film 31, of the cover plate 32 may be uneven, thereby enhancing the utilization rate of incident light. The cover plate 32 includes a first cover plate and a second cover plate. The first cover plate opposes the first encapsulation film, and the second cover plate opposes the second encapsulation film. Alternatively, the first cover plate opposes one side of the back contact solar cell, and the second cover plate opposes the other side of the back contact solar cell.

Although the present disclosure has been disclosed above with reference to preferred embodiments, it is not intended to limit the scope of the claims. Any person skilled in the art may make various possible modifications and adjustments without departing from the inventive concept of the present disclosure. Therefore, the scope of protection of the present disclosure shall be defined by the appended claims of the present disclosure. In addition, the embodiments described in the specification and the accompanying drawings of the present application are provided solely for illustrative purposes and do not constitute the entire scope of protection defined by the claims.

Those of ordinary skill in the art can understand that the aforementioned embodiments are specific examples for implementing the present disclosure. In practical applications, various modifications can be made to them in form and detail without deviating from the scope of the present disclosure. A person skilled in the art may make various alterations and modifications without departing from the scope of the present disclosure, and thus the scope of protection of the present disclosure should be determined by the scope of the appended claims.

## Claims

1. A solar cell, comprising:
a substrate (100), wherein the substrate has a first surface (101) and a second surface (102) opposite to the first surface, the first surface has first regions (11) and second regions (12) alternatingly arranged thereon, and the second regions are grooves (103) with respect to the first regions;
a passivation contact structure (110) located at least over the first regions, wherein the passivation contact structure has a first side surface abutting one of the grooves, the one of the grooves has a second side surface connected to the first side surface, one of the first side surface and the second side surface has a recess (120) recessed inward along a first direction, the recess comprises a first facet (121) and a second facet (122) connected to the first facet, one of the first facet and the second facet is connected to an adjacent first region, and a first obtuse angle (α) is formed between the first facet and the second facet, wherein the first direction is a direction pointing from a respective second region towards an adjacent first region;
a passivation layer (131) formed over the passivation contact structure and the grooves; and
a first electrode (132), arranged on the passivation layer and electrically connected to the passivation contact structure.

2. The solar cell according to claim 1, wherein the recess is formed on a side surface of the one of the grooves, and a ratio of a length of the second facet to a length of the first facet ranges from 8 to 30.

3. The solar cell according to claim 2, wherein a depth of the recess along the first direction is less than or equal to 200 nm.

4. The solar cell according to claim 1, wherein the passivation contact structure comprises a tunneling dielectric layer and a doped semiconductor layer, wherein the tunneling dielectric layer is located on the first regions, the doped semiconductor layer is located on the tunneling dielectric layer, and the recess is formed on a side surface of the doped semiconductor layer, wherein a ratio of a length of the second facet to a length of the first facet ranges from 8 to 30.

5. The solar cell according to claim 4, wherein the doped semiconductor layer is doped with an N-type doping element, and a depth of the recess along the first direction is less than or equal to 800 nm.

6. The solar cell according to claim 4, wherein the doped semiconductor layer is doped with a P-type doping element, wherein the doped semiconductor layer comprises a first portion and a second portion connected to the first portion, the first portion is located on the tunneling dielectric layer, the second portion extends along an end of the first portion to an adjacent groove, and the recess is formed on a side surface of the second portion.

7. The solar cell according to claim 6, wherein a depth of the recess along the first direction is less than or equal to 200 nm.

8. The solar cell according to claim 6, wherein a length of the second portion along the first direction is less than or equal to 1 µm.

9. The solar cell according to claim 1, wherein inner wall surfaces of the grooves have micro-textured structures comprising pyramidal structures, quasi-pyramidal structures, prismatic structures, or quasi-prismatic structures.

10. The solar cell according to claim 1, wherein the passivation layer covers the first facet and the second facet, wherein the passivation layer has a third side surface and a fourth side surface, the third side surface corresponds to the first facet, the fourth side surface corresponds to the second facet, a second obtuse angle is formed between the third side surface and the fourth side surface, and the second obtuse angle is less than or equal to the first obtuse angle.

11. The solar cell according to claim 1, wherein the first obtuse angle ranges from 100 ° to 140 °.

12. The solar cell according to claim 1, wherein a third obtuse angle is formed between a bottom surface of the groove and a side surface of the groove, and the third obtuse angle ranges from 110 ° to 150 °.

13. The solar cell according to any one of claims 1 to 12, further comprising: a second electrode located on the second surface.

14. The solar cell according to any one of claims 1 to 12, further comprising:
a second passivation contact structure, wherein the second passivation contact structure is located in the second regions, and the passivation layer covers the second passivation contact structure; and
a second electrode, located on the second regions and electrically connected to the second passivation contact structure.

15. A photovoltaic module, comprising:
a cell string, formed by connecting a plurality of solar cells according to any one of claims 1 to 14;
an encapsulation film, configured for covering a surface of the cell string; and
a cover plate, configured for covering a surface of the encapsulation film facing away from the cell string.
